# EUROPEAN PATENT SPECIFICATION

(11) **EP 1 352 008 B1**
(45) Date of publication and mention of the grant of the patent: **29.06.2005**
(21) Application number: 02710526.1
(22) Date of filing: 08.01.2002
(51) Int. Cl.: C08G 59/62, C08L 63/00, H01L 23/29

(54) **EPOXY RESIN COMPOSITION FOR SEMICONDUCTOR ENCAPSULATION**
EPOXYHARZZUSAMMENSETZUNG ZUR EINKAPSELUNG VON HALBLEITERN
COMPOSITION DE RESINE EPOXY DESTINEE A L'ENCAPSULATION DE SEMICONDUCTEUR

(30) Priority: 19.01.2001 JP 2001011383
(43) Date of publication of application: 15.10.2003
(73) Proprietor: Resolution Research Nederland B.V., 3196 KK Vondelingenplaat RT (NL)
(72) Inventor: HAYAKAWA, Atsuhito, Research and Development Lab, Yokkaichi-city, Mie-Prefecture 510-0851 (JP); MURATA, Yasuyuki, Research and Development Lab, Yokkaichi-city, Mie-Prefecture 510-0851 (JP)
(74) Representative: van der Straaten, Jan Anthony
(86) International application number: PCT/NL2002/000008
(87) International publication number: WO 2002/057333

(56) References cited:
- US-A- 5 578 660
- PATENT ABSTRACTS OF JAPAN vol. 017, no. 339 (C-1075), 28 June 1993 (1993-06-28) & JP 05 039439 A (NIPPON KAYAKU CO LTD), 19 February 1993 (1993-02-19)
- PATENT ABSTRACTS OF JAPAN vol. 018, no. 462 (C-1243), 29 August 1994 (1994-08-29) & JP 06 145306 A (MITSUI TOATSU CHEM INC), 24 May 1994 (1994-05-24)

## Description

The present invention relates to an epoxy resin composition for semiconductor encapsulation, which has a low melting viscosity, and has an excellent storage stability and moldability, and which gives a cured product having excellent solder crack resistance.

Epoxy resin compositions are widely used for adhesion, casting, encapsulation, lamination, molding, coating and the like because of its excellent curing properties and easy handling. Further,there are various kinds of epoxy resins, and curing properties greatly vary depending on its selection. For those reasons, epoxy resins are used properly in accordance with the purpose of use.

However, in recent years, various characteristics required of polymeric materials become strict as the use conditions of the polymeric materials become severe, and in various epoxy resins generally used, the required characteristics cannot sufficiently be satisfied.

For example, epoxy resin compositions are used for semiconductor encapsulation, but the required performances become strict even in this field. That is, a high degree of integration of semiconductor devices proceeds, resulting in a large-sized semiconductor element and also a small-sized and thin package. Further, the mounting technology of the semiconductor device is transfering to surface mounting. In surface mounting, in particular, a semiconductor device is directly dipped in a solder bath, and therefore exposed to high temperature. As a result, a large stress is applied to the entire package due to a rapid expansion of the absorbed moisture, and this stress causes cracks in an encapsulant. For this reason, an epoxy resin composition for a semiconductor encapsulation having good solder crack resistance is required to have a low moisture absorption and low stress properties.

It is widely conducted to improve the low moisture absorption and low stress properties (that is, low modulus of elasticity) by highly filling an inorganic filler such as a fused silica powder, and this is greatly effective to the improvement of the solder crack resistance. However, if the inorganic filler is highly filled, its fluidity at the time of molding is impaired. Therefore, it has also been required for an epoxy resin for an encapsulant to have a low melt viscosity.

Further, with advancement of package miniaturization and the package becoming thiner, high fluidity is also required of an epoxy resin composition for encapsulation, and the requirement of low melt viscosity to the epoxy resin becomes severer.

Further, moldability (that is, rapid curability) is also strongly required in order to increase a molding cycle from the standpoint of productivity improvement of the semiconductor devices, and the reality is that materials not having rapid curability, even though having other good properties, are not used.

Compositions for encapsulation comprising a blend of cresol novolak type epoxy resins and phenolic resins, are mainly used at present, and are excellent in rapid curability. However, it can no longer be said that they are sufficient in low moisture absorption and low melt viscosity.

In recent years, it is widely studied to use a biphenyl type epoxy resin of a low melt viscosity (Japanese Patent Application Laid-open No. Sho 61-47725), and such a resin is already put into practical use. In the case of using this epoxy resin, such properties as low moisture absorption, low stress or the like may be improved. However, when formulated with a conventional hardener, the rapid curability is insufficient, and this is a great productivity problem.

The document US-A 5,578,660 gives a formulation based on an epoxy resin and the curatives are phenolic resins and an accelerator. The storage stability and the flame retardancy and solder crack resistance are low.

From JP-A 05 039439 the person skilled in the art may learn that the use of diphenol compounds, with the aromatic rings linked by an oxygen, a sulphur or a sulfoxide functionality could lead to an excellent moisture-resistance and thermal shock resistance. The abstract leads the reader to the conclusion that the oxygen link (with e.g. 4,4'-dihydroxydiphenyl ether) is the prefer diphenol compound to achieve the descript set of performance.

JP-A 06 145306 teaches that the combination of thiodiphenol compound with an epoxy resin provide excellent workability and moldability, no effect on the solder crack resistance or the flame retardency properties of the molding material are given in the abstract.

An added amount of a curing accelerator in the composition can be increased in order to improve the curability, but in this case, storage stability as an encapsulant deteriorates, and is therefore not practical.

As described above, it has been generally difficult to realize moldability and solder crack resistance with a good balance in an epoxy resin composition for semiconductor encapsulation.

The present invention has an object to provide an epoxy resin composition for semiconductor encapsulation, which has a low melt viscosity and is also excellent having in low moisture absorption and low stress properties, thereby giving a cured product having excellent solder crack resistance and moldability.

As a results of extensive research and experimentation there has now surprinsingly been found that the object can be achieved by combining a biphenol type epoxy resin excellent in low moisture absorption and low stress properties, and thiodiphenol compound and polyhydric phenol compound as a phenol type hardener.

Accordingly, the present invention relates to:

An epoxy resin composition for semiconductor encapsulation, comprising, as essential components
(a) as an epoxy resin, a biphenol type epoxy resin represented by general formula (I): 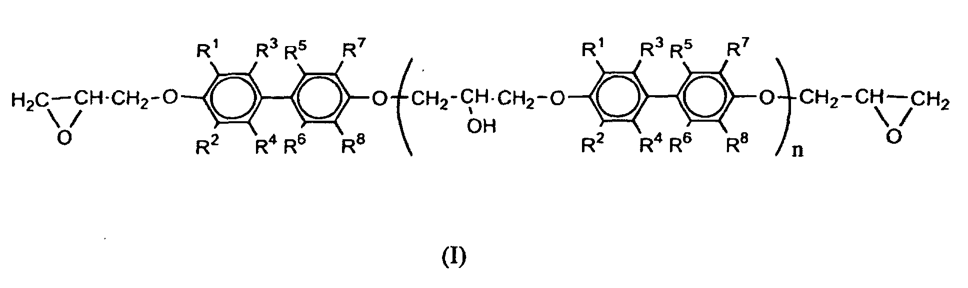 (where R¹-R⁸ may each be the same or different, and represent hydrogen, an alkyl group having 1-12 carbon atoms, a substituted or unsubstituted phenyl group, a substituted or unsubstituted aralkyl group, or an alkoxyl group, and n is a number of 0-5 on the average value);
(b) a phenol type hardener,
   (b-1) a thiodiphenol compound represented by general formula (II) 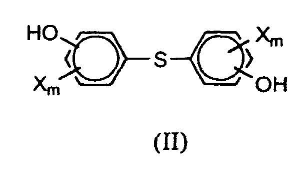 in an amount of 1-90% by weight in component (b): (where X each may be the same or different and represents an alkyl group having 1-12 carbon atoms, a substituted or unsubstituted phenyl group, a substituted or unsubstituted aralkyl group, or an alkoxyl group, and m may each be the same or different and is an integer of 0-3);
   (b-2) a polyhydric phenol compound having a structure other than component (b-1), in an amount of 10-99% by weight in component (b);
(c) an inorganic filler in an amount of 75-95% by weight of the entire composition; and (d) a curing accelerator.

More in particular the invention relates to an epoxy resin composition for semiconductor encapsulation, is characterized in that as the epoxy resin (a), the biphenol type epoxy resin represented by R¹=R²=R⁷=R⁸=CH₃, and R³=R⁴=R⁵=R⁶=H in the general formula (I) is used.

In a special embodiment of said epoxy resin composition for semiconductor encapsulation , is characterized in that as the epoxy resin (a), the biphenol type epoxy resin obtained by reacting one mole of 3,3',5,5'-tetramethyl-4,4'-biphenol with 5-30 moles of an epihalohydrin in the presence of an alkali metal hydroxide is used.

A more special embodiment of the here in before defined epoxy resin composition for semiconductor encapsulation, is characterized in that as the epoxy resin (a), the biphenol type epoxy resin mixture obtained by reacting a mixture of 4,4'-biphenol and 3,3',5,5-tetramethyl-4,4'-biphenol with an epihalohydrin in an amount of 3-15 moles per one mole of phenolic hydroxyl groups of the mixture of the said phenol compounds in the presence of an alkali metal hydroxide is used.

A preferred epoxy resin composition for semiconductor encapsulation, is characterized in that as the thiodiphenol compound (b-1), at least one kind of thiodiphenol compound selected from the group consisting of bis(4-hydroxyphenyl)sulfide, bis(4-hydroxy-3-methylphenyl)sulfide, bis(4-hydroxy-3,5-dimethylphenyl)sulfide and bis(4-hydroxy-3-tert-butyl-6-methylphenyl)sulfide is used.

A more preferred embodiment of the epoxy resin composition for semiconductor encapsulation, is characterized in that as the polyhydric phenol compound (b-2), at least one kind of polyhydric phenol compound selected from the group consisting of phenol novolak resin, phenol aralkyl resin, terpene phenolic resin, dicyclopentadiene phenolic resin and naphthol novolak resin is used.

A more preferred embodiment of the epoxy resin composition for semiconductor encapsulation, is characterized in that as the inorganic filler (c), crushed type and/or spherical, fused silica powder and/or crystalline silica powder is contained in an amount of 83-93% by weight of the entire composition.

Most preferably the epoxy resin composition for semiconductor encapsulation, is characterized in that as the curing accelerator (d), at least one kind of curing accelerator selected from the group consisting imidazoles, amines, organic phosphorous compounds, and their salts is used.

The epoxy resin (a) used in the epoxy resin composition for semiconductor encapsulation of the present invention is not particularly limited so long as it is an epoxy resin represented by the above general formula (I), and includes, for example, epoxy resins obtained by reacting 4,4'-dihydroxybiphenyls with an epihalohydrin in the presence of an alkali metal hydroxide.

Examples of 4,4'-dihydroxybiphenyls as a raw material for producing the biphenol type epoxy resin include 4,4'-biphenol, 3,3'-dimethyl-4,4'-biphenol, 3,5-dimethyl-4,4'-biphenol, 3,5-dibutyl-4,4'-biphenol, 3,3'-diphenyl-4,4'-biphenol, 3,3',5,5'-tetramethyl-4,4'-biphenol, 3,3'-dimethyl-5,5'-dibutyl-4,4'-biphenol and 3,3',5,5'-tetrabutyl-4,4'-biphenol.

Those 4,4'-dihydroxybiphenyls may be used alone or as mixtures thereof as a raw material for producing the epoxy resin. Of those, 4,4'-biphenol and 3,3',5,5'-tetramethyl-4,4'-biphenol are preferable from the point of curing properties.

Reaction of those 4,4'-dihydroxybiphenyls and an epihalohydrin is conducted by conventional known methods, and a representative embodiment thereof is described in detail below.

First, 4,4'-Dihydroxybiphenyls are dissolved in an epihalohydrin in an amount corresponding to 3-15 moles per mole of phenolic hydroxyl group in 4,4'-dihydroxybiphenyls to prepare a homogeneous solution. While stirring the solution, an alkali metal hydroxide in an amount of 0.9-2 moles per mole of phenolic hydroxyl groups is added thereto in the form of a solid or an aqueous solution to conduct reaction. This reaction can be conducted under ordinary or reduced pressure, and the reaction temperature is generally about 30-105°C in the case of the reaction under ordinary pressure and about 30-80°C in the case of the reaction under reduced pressure. The reaction is conducted such that water is removed from a reaction system by returning an oily component of condensate to the system which is obtained by cooling volatilized vapor followed by oil/water reparation and water withdrawal, while,if necessary, using azeotrope under maintaining the reaction temperature at a defined one. The alkali metal hydroxide is added intermittently or continuously in small portions over 1-8 hours in order to suppress rapid reaction. The overall reaction time is generally about 1-10 hours.

After completion of the reaction, insoluble salts by-produced are removed by filtration or removed by water washing, and unreacted epihalohydrin is then removed by distillation under reduced pressure, thereby the desired epoxy resin is obtained.

Epichlorohydrin or epibromohydrin is generally used as the epihalohydrin in this reaction. Further, NaOH or KOH is generally used as the alkali metal hydroxide.

Further, the reaction may use a catalyst, for example, quaternary ammonium salts such as tetramethylammonium chloride or tetraethylammonium bromide; tertiary amines such as benzyldimethylamine, 2,4,6-tris(dimethylaminomethyl)phenol; imidazoles such as 2-ethyl-4-methylimidazole or 2-phenylimidazole; phosphonium salts such as ethyltriphenylphosphonium iodide; and phosphines such as triphenylphosphine.

Further, the reaction may use an inert organic solvent, for example, alcohols such as ethanol or 2-propanol, ketones such as acetone or methyl ethyl ketone; ethers such as dioxane or ethylene glycol dimethyl ether; glycol ethers such as methoxypropanol; and aprotic polar solvents such as dimethylsulfoxide or dimethylformamide.

In the case that the amount of saponified halogen of the epoxy resin obtained above is large, the epoxy resin can be re-treated to obtain a purified epoxy resin having sufficiently decreased amount of saponified halogen. That is, the crude epoxy resin is re-dissolved in an inert organic solvent such as 2-propanol, methyl ethyl ketone, methyl isobutyl ketone, toluene, xylene, dioxane, methoxypropanol or dimethylsulfoxide, the alkali metal hydroxide is added thereto in the form of a solid or an aqueous solution, and recyclization reaction is conducted at a temperature of about 30-120°C for 0.5-8 hours. Thereafter, excess alkali metal hydroxide or salts by-produced are removed by a method such as water washing, and the organic solvent is distilled off under reduced pressure, thereby a purified epoxy resin is obtained.

Further, in order to maintain a low melt viscosity of the biphenol type epoxy resin and sufficiently obtain the effect of the present invention, it is preferable that n in the general formula (I) is n=0-0.2.

The epoxy resin derived from 3,3',5,5'-tetramethyl-4,4'-biphenol is commercially available as, for example, Epikote YX4000 (trade name, a product of Japan Epoxy Resins Co., Ltd.), and a mixed epoxy resin of an epoxy resin derived from 4,4'-biphenol and an epoxy resin derived from 3,3',5,5'-tetramethyl-4,4'-biphenol is commercially available as, for example, YL6121H. The present invention may be practiced using those commercially available products.

Further, in the present invention, in order to control handling properties or curing properties of the composition, the aforementioned biphenol type epoxy resin can be used by mixing other epoxy resin therewith.

Examples of other epoxy resins that can be mixed include epoxy resins produced from various phenols (e.g., bisphenol A, bisphenol F, bisphenol AD, bisphenol S, thiodiphenol, hydroquinone, methylhydroquinone, dibutylhydroquinone, resorcin, methylresorcin, dihydroxydiphenylether, thiodiphenol, dihydroxynaphthalene, etc.) or polyhydric phenolic resins obtained by polycondensation reaction of various phenols and various aldehydes (e.g., hydroxybenzaldehyde, crotonealdehyde, glyoxal, etc.), and an epihalohydrin; epoxy resins produced by various amine compounds such as diaminodiphenylmethane, aminophenol or xylenediamine, and an epihalohydrin; and epoxy resins produced from various carboxylic acids such as methylhexahydroxyphthalic acid or dimer acid, and an epihalohydrin.

The amount of other epoxy resins used is preferably 100 parts by weight or less, more preferably 50 parts by weight or less, per 100 parts by weight of the biphenol type epoxy resin. If the amount of other epoxy resins used is too large, the effect of the present invention is not sufficiently exhibited.

The thiodiphenol compound (b-1) is compounded, as one component of the phenol type hardener, with the epoxy resin composition for semiconductor encapsulation of the present invention. The thiodiphenol compound is not limited so long as it has the structure represented by the aforementioned general formula (II). Examples of the compound include bis(4-hydroxyphenyl)sulfide, bis(2-hydroxyphenyl) sulfide, 2-hydroxyphenyl-4'-hydroxyphenylsulfide, bis(4-hydroxy-3-methylphenyl)sulfide, bis(4-hydroxy-3,5-dimethylphenyl)sulfide, bis(4-hydroxy-2-methyl-5-tert-butylphenyl)sulfide, bis(4-hydroxy-3-methyl-5-tert-butylphenyl)sulfide, bis(4-hydroxy-3-tert-butyl-6-methylphenyl)sulfide, and bis(4-hydroxy-3,5-di-tert-butylphenyl)sulfide.

From easy availability and curing properties, bis(4-hydroxyphenyl)sulfide, bis(4-hydroxy-3-methylphenyl)sulfide, bis(4-hydroxy-3,5-dimethylphenyl)sulfide and bis(4-hydroxy-3-tert-butyl-6-methylphenyl)sulfide are preferable, and bis(4-hydroxyphenyl)sulfide is more preferable.

As another component (b-2) of the phenol type hardener (b), conventional known compounds can be used as the polyhydric phenol compound having the structure other than the component (b-1), and examples thereof include various phenolic resins such as polyhydric phenolic resins obtained by condensation reaction of polyhydric phenols (e.g., bisphenol A, bisphenol F, bisphenol S, hydroquinone, resorcin, biphenol, tetramethylbiphenol, dihydroxynaphthalene, dihydroxydiphenyl ether, phenol novolak resin, cresol novolak resin, bisphenol A novolak resin, naphthol novolak resin, etc.) or various phenols, and various aldehydes (e.g., benzaldehyde, hydroxybenzaldehyde, crotonealdehyde, glyoxal, etc.); and modified phenolic resins obtained by polycondensation reaction of phenol aralkyl resin, phenol terpene resin, dicyclopentadiene phenolic resin, heavy oils or pitches, phenols and aldehyde compound.

From moldability and solder crack resistance, phenol novolak resin, phenol aralkyl resin, terpene phenolic resin, dicyclopentadiene phenolic resin and naphthol novolak resin are preferable, and phenol aralkyl resin is more prefereable.

Those polyhydric phenol compounds (b-2) may be used alone or as mixtures of two kinds or more.

In the phenol type hardener (b) that is the essential component in the epoxy resin composition for semiconductor encapsulation of the present invention, the proportion of each component used is 10-99% by weight of the polyhydric phenol compound (b-2) having the structure other than component (b-1) to 1-90% by weight of the thiodiphenol compound (b-1). If the thiodiphenol compound (b-1) is less than 1% by weight, curability decreases, so that sufficient moldability is not obtained. If it is more than 90% by weight, mechanical properties (strength and the like) of the cured product obtained become insufficient. From the balance of the above various properties, the use proportion of component (b-1) and component (b-2) is preferably 30-97% by weight of (b-2) to 3-70% by weight of (b-1), more preferably 45-95% by weight of (b-2) to 5-55% by weight of (b-1).

Hardeners other than the phenol type hardener (b) can be mixed with the epoxy resin composition for semiconductor encapsulation of the present invention. Examples of the hardener that can be mixed include acid anhydrides such as methyltetrahydrophthalic anhydride, hexahydrophthalic anhydride, pyromellitic anhydride or methylnadic acid; amines such as diethylenetriamine, isophoronediamine, diaminodiphenylmethane, diaminodiphenylsulfone or dicyandiamide; and activated ester compounds obtained by esterifying, such as benzoating or acetating, the whole or part of phenolic hydroxyl groups in various phenol compounds exemplified in the examples of the phenol type hardener (b).

The amount of those other hardeners used is preferably 50% by weight or less to the total amount of phenol type hardeners. If the use amount of the hardener other than the epoxy resin hardener of the present invention is too much, the effect of the present invention is not sufficiently exhibited.

Each component of those hardeners may be used by previously mixing to prepare a mixed hardener, or mixed with various components when producing the epoxy resin composition, each component of the hardener for epoxy resin may separately be added and then simultaneously mixed together.

The use amount of the hardener used is such that the amount of groups that react with epoxy groups in the entire hardeners is preferably 0.5-2.0 moles, more preferably 0.7-1.2 moles, per mole of epoxy groups in the entire epoxy resin components.

The inorganic filler component (c) is blended with the epoxy resin composition for semiconductor encapsulation of the present invention. Examples of the inorganic filler include fused silica, crystalline silica, glass powder, alumina and calcium carbonate. The shape thereof is a crushed form or a spherical form. Various inorganic fillers are used alone or as mixtures of two kinds or more. Of those, fused silica or crystalline silica is preferable. The amount of the inorganic filler used is 75-95% by weight, more preferably 83-93% by weight, of the entire composition.

If the amount of the inorganic filler of component (c) is too small, the improvement effect of low moisture absorption is small, resulting in poor solder crack resistance. If the amount of the inorganic filler (c) is too much, its fluidity in molding is impaired because of not having low melt viscosity.

The curing accelerator (d) used in the epoxy resin composition for semiconductor encapsulation of the present invention is a compound that accelerates reaction between epoxy groups in the epoxy resin and active groups in the hardener.

Examples of the curing accelerator include phosphine compounds such as tributyl phosphine, triphenyl phosphine, tris(dimethoxyphenyl)phosphine, tris(hydroxypropyl)phosphine and tris(cyanoethyl)phosphine; phosphonium salts such as tetraphenyl phosphonium tetraphenyl borate, methyl tributylphosphonium tetraphenyl borate and methyl tricyanoethyl phosphonium tetraphenyl borate; imidazoles such as 2-methyl imidazole, 2-phenyl imidazole, 2-ethyl-4-methyl imidazole, 2-undecyl imidazole, 1-cyanoethyl-2-methyl imidazole, 2,4-dicyano-6-[2-methyl imidazolyl-(1)]-ethyl-S-triazine and 2,4-dicyano-6-[2-undecyl imidazolyl-(1)]-ethyl-S-triazine; imidazolium salts such as 1-cyanoethyl-2-undecylimidazolium trimellitate, 2-methylimidazolium isocyanurate, 2-ethyl-4-methylimidazolium tetraphenyl borate and 2-ethyl-1,4-dimethylimidazolium tetraphenyl borate; amines such as 2,4,6-tris(dimethylaminomethyl)phenol, benzyl dimethylamine, tetramethylbutyl guanidine, N-methyl piperazine and 2-dimethylamino-1-pyrroline; ammonium salts such as triethylammoniumtetraphenyl borate; diazabicyclo compounds such as 1,5-diazabicyclo(5,4,0)-7-undecene, 1,5-diazabicyclo(4,3,0)-5-nonene and 1,4-diazabicyclo(2,2,2)octane; and tetraphenyl borates, phenol salts, phenol novolak salts and 2-ethylhexanoic acid salts of those diazabicyclo compounds. Of the compounds used as those curing accelerators, phosphine compounds, imidazole compounds, diazabicyclo compounds and their salts are preferable.

Various additives can be blended with the epoxy resin composition for semiconductor encapsulation of the present invention, similar to other general epoxy resin compositions. Examples of such various additives include coupling agents, flame retardants, plasticizers, reactive diluents and pigments. Those can appropriately be blended according to the need.

Examples of the flame retardant include halogen type flame retardants such as brominated epoxy resin and brominated phenolic resin; antimony compounds such as antimony trioxide; phosphorus type flame retardants such as phosphoric acid esters and phosphines; nitrogen type flame retardants such as melamine derivatives; and inorganic flame retardants such as aluminum hydroxide and magnesium hydroxide.

However, recently, from the standpoint of deterioration of characteristics or environmental protection, it is desirable to not blend the above-mentioned flame retardants. Since the cured product of the epoxy resin composition for semiconductor encapsulation of the present invention has excellent flame retardancy, it is not necessary to blend those flame retardants, or it is possible to decrease the flame retardants used to a small amount.

The epoxy resin composition for semiconductor encapsulation of the present invention has low melt viscosity, is excellent in storage stability and moldability, and gives a cured product having excellent solder crack resistance, and therefore can advantageously be used in the field of semiconductor encapsulation.
Moreover these epoxy compositions show in a cured state a flame-retardation property, without the use of halogenated compounds.

### EXAMPLE

Production examples of the components for epoxy resin composition for semiconductor encapsulation of the present invention, and examples and comparative examples of the epoxy resin composition for semiconductor encapsulation of the present invention are shown below.

### Production Example 1 of Biphenyl Type Epoxy Resin of Component (a)

200 g of 3,3,5,5'-tetramethyl-4,4'-biphenol, 917 g of epichlorohydrin and 357 g of 2-propanol were charged in a 3 liters four-necked flask equipped with a thermometer, a stirring device and a cooling pipe, and temperature in the system was elevated to 40°C. Thereafter, 157 g of 48.5 wt% sodium hydroxide aqueous solution was added dropwise over 90 minutes. During the addition, temperature was gradually elevated such that the system reached 65°C after completion of the dropwise addition. The system was maintained at 65°C for 30 minutes to complete reaction, and salts by-produced and excess sodium hydroxide were removed by water washing. Excess epichlorohydrin and 2-propanol were distilled off from the reaction product under reduced pressure to obtain a crude epoxy resin.

This crude epoxy resin was dissolved in 683 g of methyl isobutyl ketone, 10 g of 48.5 wt% sodium hydroxide aqueous solution was added thereto, and reaction was conducted at a temperature of 65°C for 1 hour. Thereafter, monosodium phosphate was added to the reaction mixture to neutralize excess sodium hydroxide, followed by water washing to remove salts by-produced. Methyl isobutyl ketone was completely removed under reduced pressure to obtain 286 g of the desired epoxy resin. The epoxy resin obtained had an epoxy equivalent of 186 g/eq., and a viscosity at 150°C of 0.2P.

### Production Example 2 of Biphenyl Type Epoxy Resin of Component(a)

90 g of 4,4'-biphenol, 100 g of 3,3',5,5'-tetramethyl-4,4'-biphenol, 995 g of epichlorohydrin and 387 g of 2-propanol were charged, reaction was conducted in the same manner as in Production Example 1 to obtain 281 g of the desired epoxy resin. The epoxy resin obtained had an epoxy equivalent of 171 g/eq., and a viscosity at 150°C of 0.1P.

### Epoxy Resin Composition Examples 1-6 and Comparative Examples A-C

The epoxy resin and orthocresol novolak resin type epoxy resin produced in Production Examples 1 and 2 as the biphenyl type epoxy resin; phenol novolak resin, phenol aralkyl resin, naphthol aralkyl resin, dicyclopentadiene phenolic resin and terpene phenolic resin as the hardener; tetrabromobisphenol A type epoxy resin as the brominated epoxy resin; silica powder as the inorganic filler; triphenylphosphine as the curing accelerator, antimony trioxide as the flame retardant; epoxysilane as the coupling agent; and carnauba wax as the release agent were respectively used as shown in Table 1 to formulate each epoxy resin composition.

The proportions of the thiodiphenol compound (b-1) and the polyhydric phenol compound (b-2) in the phenol type hardener (b) in Example 1 are 5% by weight and 95% by weight, respectively, those in Example 2 are 10% by weight and 90% by weight, respectively, those in Example 3 are 20% by weight and 80% by weight, respectively, those in Example 4 are 30% by weight and 70% by weight, respectively, those in Example 5 are 40% by weight and 60% by weight, respectively, and those in Example 6 are 60% by weight and 40% by weight, respectively.

Each blend was melt kneaded at a temperature of 70-120°C for 5 minutes using a mixing roll. Each molten mixture obtained was taken out in the form of thin sheet, and the sheet was cooled and then pulverized to obtain each molding material. Each molding material was molded with a low pressure transfer molding machine at a mold temperature of 175°C and a molding time of 180 seconds to obtain each test piece, and each test piece was post-cured at 180°C for 8 hours. Further, spiral flow was measured in order to examine fluidity and storage stability of each molding material, and gel time and hot hardness at mold releasing were measured in order to examine moldability of each molding material.

Further, moisture absorption, modulus of elasticity and flame retardancy of each test piece after post-curing were tested. Furthermore, solder crack resistance of a dummy semiconductor device encapsulated with each molding material was tested. All of those results are shown in Table 1.

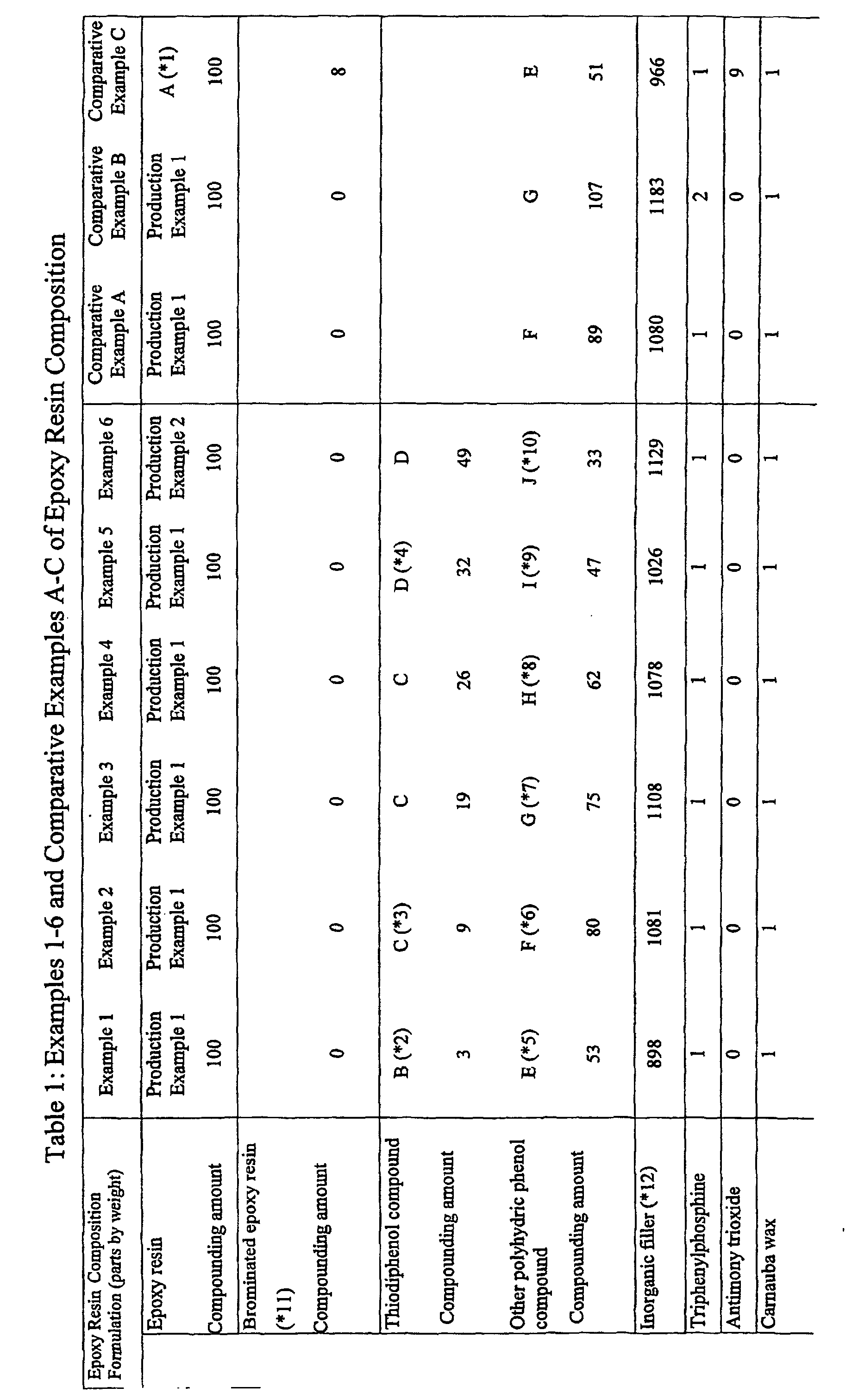

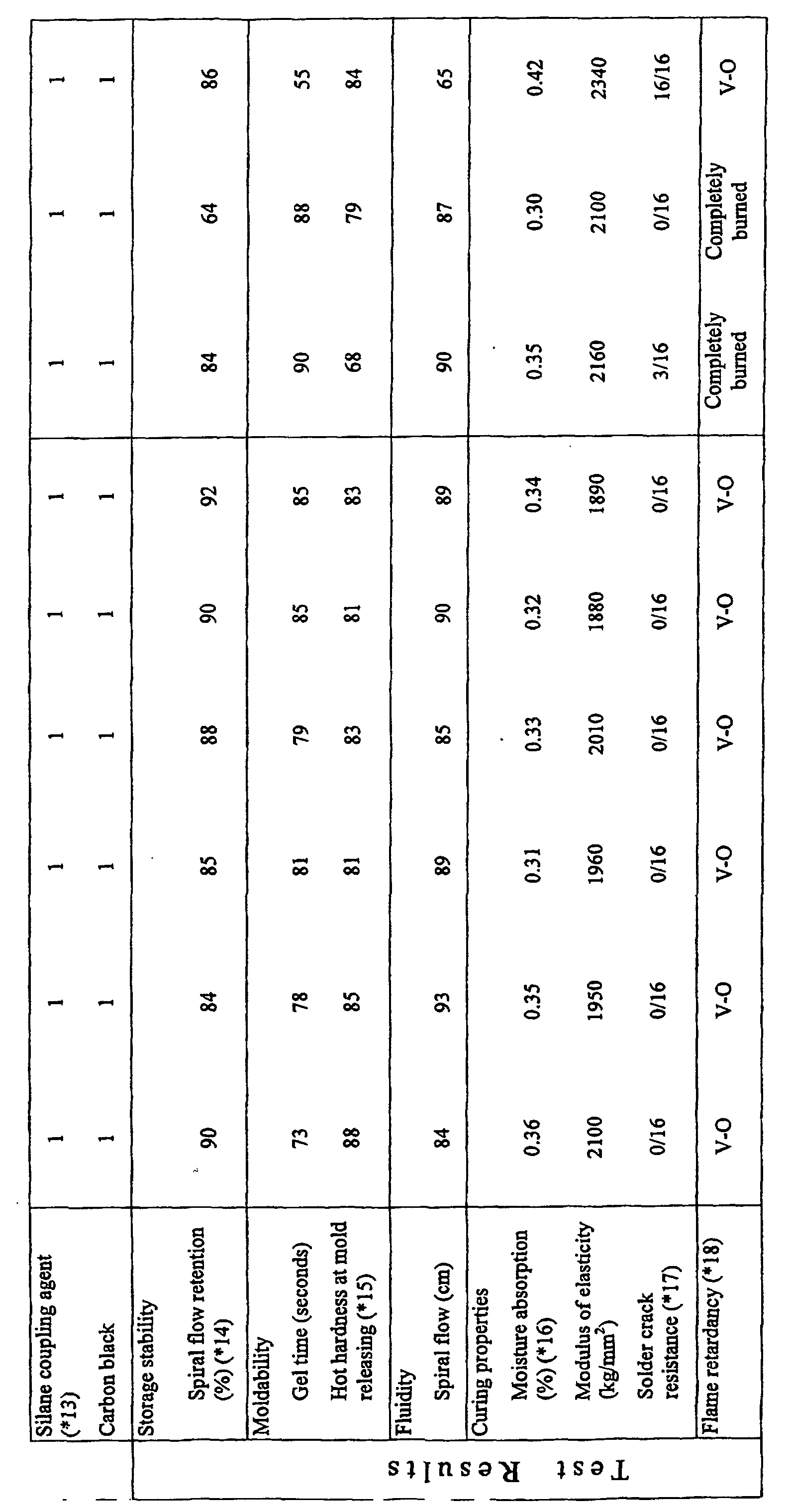

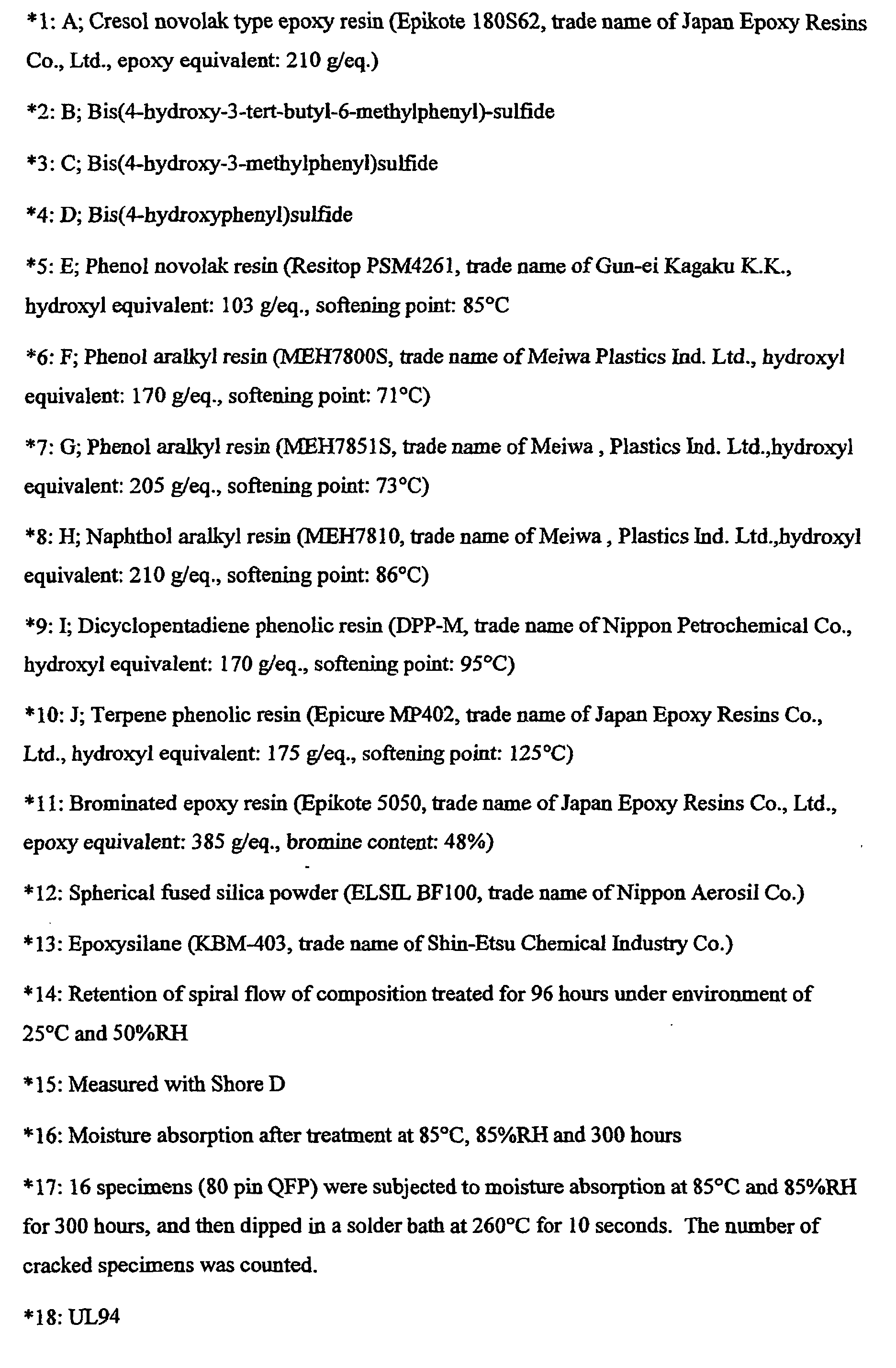

As is apparent from Table 1, each molding material of Examples 1-6 is excellent in balance of storage stability (i.e., high spiral flow retention), fluidity (i.e., high spiral flow), moldability (i.e., high hot hardness at mold releasing), moisture resistance (i.e., a low moisture absorption), and low stress (i.e., low modulus of elasticity), and is also excellent in solder crack resistance, as compared with the molding materials of Comparative Examples A-C. Further, each molding material of Examples 1-6 does not contain a harmful halogen type flame retardant, and is excellent in flame retardancy.

The epoxy resin composition for semiconductor encapsulation of the present invention has a low melt viscosity, is excellent in storage stability and moldability, and gives a cured product having excellent solder crack resistance, and therefore can advantageously be used in the field of semiconductor encapsulation.

## Claims

1. Composition for semiconductor encapsulation with excellent solder crack resistance and excellent flame retardancy comprising an epoxy resin composition comprising:
(a) as an epoxy resin, a biphenol type epoxy resin represented by general formula (I): 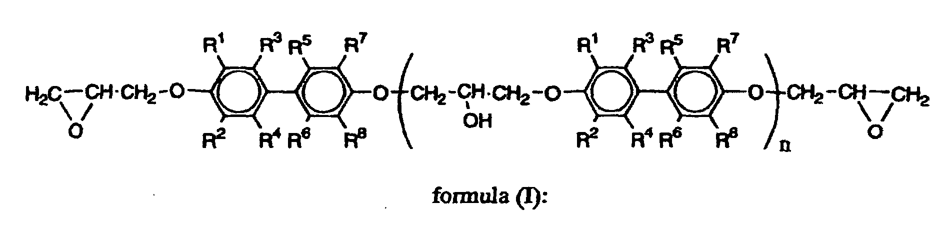 (where R¹-R⁸ may each be the same or different, and represent hydrogen, an alkyl group having 1-12 carbon atoms, a substituted or unsubstituted phenyl group, a substituted or unsubstituted aralkyl group, or an alkoxyl group, and n is a number of 0-5 on the average value);
(b) a phenol type hardener,
(b-1) a thiodiphenol compound represented by general formula (II) 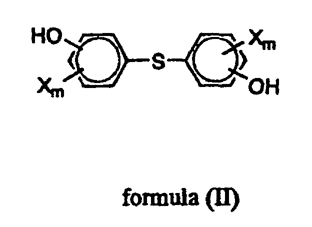 in an amount of 1-90% by weight in component (b):(where X each may be the same or different and represents an alkyl group having 1-12 carbon atoms, a substituted or unsubstituted phenyl group, a substituted or unsubstituted aralkyl group, or an alkoxyl group, and m may each be the same or different and is an integer of 0-3);
(b-2) a polyhydric phenol compound having a structure other than component (b-1), in an amount of 10-99% by weight in component (b);
(c) an inorganic filler in an amount of 75-95% by weight of the entire composition; and
(d) a curing accelerator.

2. The epoxy resin composition for semiconductor encapsulation as claimed in claim 1, **characterized in that** as the epoxy resin (a), the biphenol type epoxy resin represented by R¹=R²=R⁷=R⁸=CH₃, and R³=R⁴=R⁵=R⁶=H in the formula (I) is used.

3. The epoxy resin composition for semiconductor encapsulation as claimed in claim 1 or 2, **characterized in that** as the epoxy resin (a), the biphenol type epoxy resin obtained by reacting one mole of 3,3',5,5'-tetramethyl-4,4'-biphenol with 5-30 moles of an epihalohydrin in the presence of an alkali metal hydroxide is used.

4. The epoxy resin composition for semiconductor encapsulation as claimed in claim 1 or 2, **characterized in that** as the epoxy resin (a), the biphenol type epoxy resin mixture obtained by reacting a mixture of 4,4'-biphenol and 3,3',5,5'-tetramethyl-4,4'-biphenol with an epihalohydrin in an amount of 3-15 moles per one mole of phenolic hydroxyl groups of the mixture of the phenol compounds in the presence of an alkali metal hydroxide is used.

5. The epoxy resin composition for semiconductor encapsulation as claimed in any one of claims 1 to 4, **characterized in that** as the thiodiphenol compound (b-1), at least one kind of thiodiphenol compound selected from the group consisting of bis(4-hydroxyphenyl)sulfide, bis(4-hydroxy-3-methylphenyl)sulfide, bis(4-hydroxy-3,5-dimethylphenyl)sulfide and bis(4-hydroxy-3-tert-butyl-6-methylphenyl)sulfide is used.

6. The epoxy resin composition for semiconductor encapsulation as claimed in any one of claims 1 to 5, **characterized in that** as the polyhydric phenol compound (b-2), at least one kind of polyhydric phenol compound selected from the group consisting of phenol novolak resin, phenol aralkyl resin, terpene phenolic resin, dicyclopentadiene phenolic resin and naphthol novolak resin is used.

7. The epoxy resin composition for semiconductor encapsulation as claimed in any one of claims 1 to 6, **characterized in that** as the inorganic filler (c), crushed type and/or spherical, fused silica powder and/or crystalline silica powder is contained in an amount of 83-93% by weight of the entire composition.

8. The epoxy resin composition for semiconductor encapsulation as claimed in any one of claims 1-7, **characterized in that** as the curing accelerator (d), at least one kind of curing accelerator selected from the group consisting of imidazoles, amines, organic phosphorous compounds, and their salts is used.

9. Encapsulated semiconductor comprising an epoxy resin composition according to claims 1-8.

## Patentansprüche

1. Zusammensetzung zur Verkapselung von Halbleitern mit hervorragender Lötrissbeständigkeit und hervorragendem Flammverzögerungsvermögen, umfassend eine Epoxyharzzusammensetzung, umfassend:
(a) als Epoxyharz, ein Epoxyharz vom Biphenoltyp, das durch die allgemeine Formel (I) dargestellt wird: 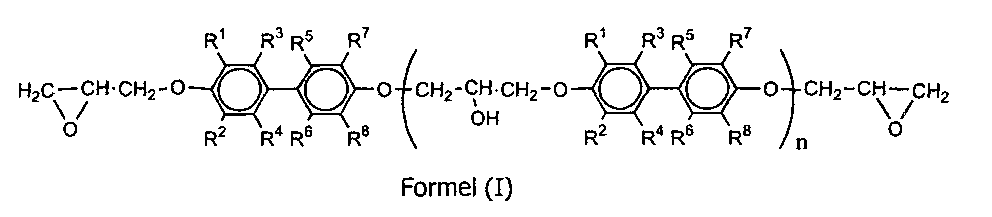 (worin R¹ - R⁸ jeweils gleich oder verschieden sein können und für Wasserstoff, eine Alkylgruppe mit 1 - 12 Kohlenstoffatomen, eine substituierte oder unsubstituierte Phenylygruppe, eine substituierte oder unsubstituierte Aralkylgruppe, oder eine Alkoxylgruppe stehen, und n für eine Zahl von 0 - 5 als Durchschnittswert steht);
(b) ein Härtungsmittel vom Phenoltyp,
(b - 1) eine Thiodiphenolverbindung, die durch die allgemeine Formel (II) dargestellt wird: 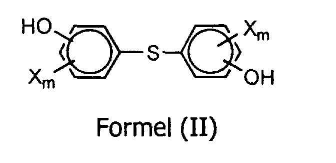 in einer Menge von 1 - 90 Gew.-% in der Komponente (b): (worin X jeweils gleich oder verschieden sein kann und für eine Alkylgruppe mit 1 - 12 Kohlenstoffatomen, eine substituierte oder unsubstituierte Phenylgruppe, eine substituierte oder unsubstituierte Aralkylgruppe, oder eine Alkoxylgruppe steht, und m jeweils gleich oder verscheiden sein kann und für eine ganze Zahl von 0 - 3 steht);
(b-2) eine mehrwertige Phenolverbindung mit einer Struktur, die von der Komponente (b-1) verschieden ist, in einer Menge von 10 - 99 Gew.-% in der Komponente (b);
(c) einen anorganischen Füllstoff in einer Mengen von 75 - 95 Gew.-% der gesamten Zusammensetzung;
und
(d) einen Härtungsbeschleuniger.

2. Epoxyharzzusammensetzung zur Verkapselung von Halbleitern gemäß Anspruch 1, **dadurch gekennzeichnet, dass** als Epoxyharz (a) das Epoxyharz vom Biphenoltyp, dargestellt durch R¹ = R² = R⁷ = R⁸ = CH₃ und R³ = R⁴ = R⁵ = R⁶ = H in der Formel (I), verwendet wird.

3. Epoxyharzzusammensetzung zur Verkapselung von Halbleitern gemäß Anspruch 1 oder 2, **dadurch gekennzeichnet, dass** als Epoxyharz (a) das Epoxyharz vom Biphenoltyp verwendet wird, das durch Umsetzung von einem Mol 3,3',5,5'-Tetramethyl-4,4'-biphenol mit 5 - 30 Molen eines Epihalohydrins in Gegenwart eines Alkalimetallhydroxids erhalten wird.

4. Epoxyharzzusammensetzung zur Verkapselung von Halbleitern gemäß Anspruch 1 oder 2, **dadurch gekennzeichnet, dass** als Epoxyharz (a) die Epoxyharzmischung vom Biphenoltyp verwendet wird, die durch Umsetzung einer Mischung von 4,4'-Biphenol und 3,3',5,5'-Tetramethyl-4,4'-biphenol mit einem Epihalohydrin in einer Mengen von 3 - 15 Mol pro einem Mol phenolischer Hydroxylgruppen der Mischung der Phenolverbindungen in Gegenwart eines Alkalimetallhydroxids erhalten wird.

5. Epoxyharzzusammensetzung zur Verkapselung von Halbleitern gemäß einem der Ansprüche 1 bis 4, **dadurch gekennzeichnet, dass** als Thiodiphenolverbindung (b-1) wenigstens eine Art Thiodiphenolverbindung, ausgewählt aus der Gruppe bestehend aus Bis(4-hydroxyphenyl)sulfid, Bis(4-hydroxy-3-methylphenyl)sulfid, Bis(4-hydroxy-3,5,dimethylphenyl)sulfid und Bis(4-hydroxy-3-tert-butyl-6-methylphenyl)sulfid, verwendet wird.

6. Epoxyharzzusammensetzung zur Verkapselung von Halbleitern gemäß einem der Ansprüche 1 bis 5, **dadurch gekennzeichnet, dass** als mehrwertige Phenolverbindung (b-2) mindestens eine Art mehrwertige Phenolverbindung eingesetzt wird, welche aus der Gruppe gewählt wird, die aus Phenol-Novolak-Harz, Phenol-Aralkyl-Harz, Terpen-Phenol-Harz, Dicyclopentadien-Phenol-Harz, Naphthol-Novolak-Harz besteht.

7. Epoxyharzzusammensetzung zur Verkapselung von Halbleitern gemäß einem der Ansprüche 1 bis 6, **dadurch gekennzeichnet, dass** als anorganischer Füllstoff (c) bruchartiges und/oder kugelförmiges Quarzglaspulver und/oder kristallines Siliciumdioxidpulver in einer Menge von 83-93 Gew.% der gesamten Zusammensetzung enthalten ist.

8. Epoxyharzzusammensetzung zur Verkapselung von Halbleitern gemäß einem der Ansprüche 1 bis 7, **dadurch gekennzeichnet, dass** als Härtungsbeschleuniger (d) mindestens eine Art Härtungsbeschleuniger verwendet wird, ausgewählt aus der Gruppe bestehend aus Imidazolen, Aminen, organischen Phosphorverbindungen und deren Salze.

9. Verkapselter Halbleiter, der eine Epoxyharzzusammensetzung gemäß einem der Ansprüche 1 bis 8 umfasst.

## Revendications

1. Une composition d'encapsulation de semi-conducteur avec une excellente résistance à la soudure et d'excellente propriété ignifuge comprenant une composition de résine époxyde comprenant:
(a) comme résine époxyde, une résine de type époxy bis-phénol représentée par la formule générale (I) : 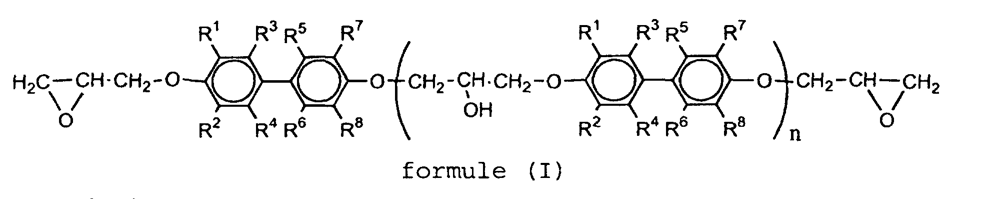 (ou R¹-R⁸ peuvent être chacun le même ou différent, et représente un hydrogène, un groupe alkyl possédant 1-12 atomes de carbone, un groupe phényle substitué ou pas,un groupe aralkyl substitué ou pas, ou un groupe alkoxyl, et n est un nombre de 0-5 en valeur moyenne) ;
(b) un durcisseur de type phénolique,
(b-1) un composé thiodiphénol représenté par la formule générale (II) 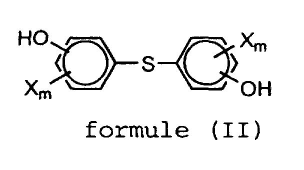 en une quantité de 1-90% en poids en composé (b) : ( ou X peut-être le même ou différent et représente un groupe alkyl possédant 1-12 atomes de carbone, un groupe phényle substitué ou pas,un groupe aralkyl substitué ou pas, ou un groupe alkoxyl, et m peut-être le même ou différent et est un nombre entier de 0-3) ;
(b-2) un composé phénol polyhydrique possédant une structure autre que le composé (b-1), en une quantité de 10-99% en poids du compose (b);
(c) une charge inorganique en une quantité de 75-95% en poids de la composition dans son entièreté ;
(d) un accélérateur de réticulation.

2. La composition d'encapsulation de semi-conducteur comme revendiquée dans la revendication 1, **caractérisée en ce que** la résine époxyde (a) utilisée est, de type époxy résine bis-phénol est représentée par R¹=R²=R⁷=R⁸=CH₃ et R³=R⁴=R⁵=R⁶=H dans la formule (I).

3. La composition d'encapsulation de semi-conducteur comme revendiquée dans la revendication 1 ou 2, **caractérisée en ce que** la résine époxyde (a) utilisée est, de type époxy résine bis-phénol obtenue par réaction d'une mole de 3,3',5,5' tetramethyl-4,4'-biphénol avec 5-30 moles d'épihalohydrine en présence d'un hydroxyde métallique.

4. La composition d'encapsulation de semi-conducteur comme revendiquée dans la revendication 1 ou 2, **caractérisée en ce que** la résine époxyde (a) utilisée est, de type époxy résine bis-phénol obtenue par réaction d'un mélange de 4,4'biphénol et 3,3',5,5' tetramethyl-4,4'-biphénol avec une épihalohydrine en une quantité de 3-15 moles par mole d'hydroxyle phénolique du mélange des composés phénolique en présence d'un hydroxyde métallique.

5. La composition d'encapsulation de semi-conducteur comme revendiquée dans une des revendications 1 à 4, **caractérisée en ce que** le composé thiodiphénol (b-1) utilisé est sélectionné d'au moins d'une sorte de composé thiodiphénol du groupe constitué de bis(4-hydroxy phényle)sulfure, bis(4-hydroxy-3-méthylephényle)sulfure, bis(4-hydroxy-3,5-diméthylephényle)sulfure, bis(4-hydroxy-3tert butyl-6-diméthylephényle)sulfure.

6. La composition d'encapsulation de semi-conducteur comme revendiquée dans une des revendications 1 à 5, **caractérisée en ce que** le composé phénol polyhydrique(b-2) utilisé est sélectionné d'au moins d'une sorte de composé phénol polyhydrique du groupe constitué de résine phénol-novolaque, d'aralkyl résine phénolique, de résine terpène phénolique, de résine dicyclopentadiène phénolique et de résine napthol-novolaque.

7. La composition d'encapsulation de semi-conducteur comme revendiquée dans une des revendications 1 à 6, **caractérisée en ce que** la charge inorganique (c) est, de type broyée et/ou sphérique, une poudre de silice fondue et/ou une poudre de silice cristalline est contenue en une quantité de 83-93% en poids sur la composition entière.

8. La composition d'encapsulation de semi-conducteurs comme revendiquée dans une des revendications 1 à 7, **caractérisée en ce que** l'accélérateur de réticulation (d)utilisé est sélectionné d'au moins d'une sorte d'accélérateur de réticulation du groupe constitué d'imidazoles,d'amines, de composés organiques phosphorés, et leurs sels.

9. Un semi-conducteur encapsulé comprenant une résine époxyde de composition selon les revendications de 1-8.
